# EUROPEAN PATENT APPLICATION

(11) **EP 4 517 789 A1**
(43) Date of publication of application: **05.03.2025**
(21) Application number: 24197045.8
(22) Date of filing: 28.08.2024
(51) Int. Cl.: H01F 27/02, H01F 27/06, H01F 27/26, H01F 27/30, H05K 7/14

(54) **POWER MODULE**

(30) Priority: 30.08.2023 CN 202311115258
(71) Applicant: Delta Electronics (Shanghai) Co., Ltd., Shanghai 201209 (CN)
(72) Inventor: LAN, Lin, 201209 Shanghai (CN); ZHANG, Quanliang, 201209 Shanghai (CN); ZHANG, Weiqiang, 201209 Shanghai (CN); XIE, Yicong, 201209 Shanghai (CN); LI, Rui, 201209 Shanghai (CN)
(74) Representative: 2K Patentanwälte Blasberg Kewitz & Reichel

(57) **Abstract**

The present application provides a power module, including a first side plate (101), a second side plate (102), and an insulating board (100). The insulating board includes a flat plate portion (110), at least one protrusion portion (120), and at least one connecting bridge (130), the flat plate portion is parallel to a plane formed by a first direction (X) and a second direction (Y); at least one of the protrusion portion and the connecting bridge protrudes along a third direction (Z) to form an insulation cavity (140); the insulating board, the first side plate, and the second side plate in combination form a first accommodating space (11) and a second accommodating space (12) along the third direction, the first accommodating space is provided with a first power device (13), and the second accommodating space is provided with a second power device (14); and a transformer (200), including a magnetic core (210) and a winding wound on the magnetic core, the winding includes a first winding (220) and a second winding (230), at least part of the magnetic core is set within the insulation cavity or the connecting bridge; the first winding is electrically connected to the first power device, and the second winding is electrically connected to the second power device. The flat plate portion in the present application does not penetrate through an air gap of the magnetic core, which facilitates a control of a size of the air gap of the magnetic core and is beneficial for improving an efficiency of the transformer in the power module.

## Description

### TECHNICAL FIELD

The present application relates to the field of electrical equipment technologies and, in particular, to a power module.

### BACKGROUND

With the development of social science and technology and economy, more and more emerging industries are gradually becoming popular. For example, in the automotive industry, the demand for electric vehicles has gradually increased in recent years, and the production and sales of electric vehicles continue to increase, with a trend of surpassing traditional cars. In terms of infrastructure, the country has included data centers in the new infrastructure category, and in recent years, the construction of big data centers has been accelerated. Basic supporting facilities are indispensable for both the development of the electric vehicle industry and the construction of data centers. And the power sourcing equipment is the core component in the supporting facilities, in the background of continuous industry development, the power sourcing equipment also faces greater challenges and higher requirements.

In related technologies, a power module includes a shell and a transformer and a voltage power device set inside the shell, a middle of the shell is provided with an insulating board, the transformer includes a primary side unit and a secondary side unit, and the voltage power device includes a first power device and a second power device. The primary side unit and the secondary side unit are symmetrically arranged relative to the insulating board; the first power device and the second power device are also symmetrically arranged relative to the insulating board, and the first power device is electrically connected to the primary side unit, the second power device is electrically connected to the secondary side unit.

However, an efficiency of the transformer in the power module is relatively low in technical solutions of related art.

### SUMMARY

In order to overcome the above defects under the relevant technologies, the purpose of the present application is to provide a power module that can improve an efficiency of a transformer in the power module.

The present application provides a power module, including:
a first side plate, a second side plate, and an insulating board;
the insulating board including a flat plate portion, at least one protrusion portion, and at least one connecting bridge, the flat plate portion being parallel to a plane formed by a first direction and a second direction; at least one of the protrusion portion and the connecting bridge protruding along a third direction to form an insulation cavity; the insulating board, the first side plate, and the second side plate in combination forming a first accommodating space and a second accommodating space along the third direction; the first accommodating space being provided with a first power device, and the second accommodating space being provided with a second power device; and
a transformer, including a magnetic core and a winding wound on the magnetic core, the winding including a first winding and a second winding, at least part of the magnetic core being set within the insulation cavity or the connecting bridge; the first winding being electrically connected to the first power device, and the second winding being electrically connected to the second power device;
where the first direction, the second direction, and the third direction are perpendicular to each other.

In the present application, since the at least part of the magnetic core is set within the insulation cavity or the connecting bridge, the flat plate portion will not penetrate through an air gap of the magnetic core, thus facilitating a control of a size of the air gap of the magnetic core and is beneficial for improving an efficiency of the transformer in the power module; in addition, the protrusion portion or connecting bridge set on the flat plate portion enables the insulating board to form a bending structure, which is beneficial for improving an overall strength of the insulating board.

### BRIEF DESCRIPTION OF DRAWINGS

In order to explain the embodiments of the present application clearly, the drawings needed to be used in the embodiments will be introduced briefly in the following. Obviously, the drawings in the following description are some embodiments of the present application. For those skilled in the art, other drawings can be obtained from these drawings without paying creative labor.
FIG. 1 is an external schematic diagram of a power module provided by an embodiment of the present application.
FIG. 2 is a structural diagram of a power module provided by an embodiment of the present application.
FIG. 3 is a structural diagram of an insulating board provided by an embodiment of the present application.
FIG. 4 is a structural diagram of an insulating board provided by another embodiment of the present application.
FIG. 5 is a structural diagram of a transformer provided by an embodiment of the present application.
FIG. 6 is a structural diagram of a transformer provided by another embodiment of the present application.
FIG. 7 is a schematic diagram of a connection structure of a transformer and an insulating board provided by an embodiment of the present application.
FIG. 8 is a schematic diagram of a connection structure of a transformer and an insulating board provided by another embodiment of the present application.
FIG. 9 is a schematic diagram of a connection structure of a transformer and an insulating board provided by still another embodiment of the present application.
FIG. 10 is a schematic diagram of a connection structure of a transformer and an insulating board provided by yet another embodiment of the present application.
FIG. 11 is a schematic diagram of a connection structure of a transformer and an insulating board provided by yet another embodiment of the present application.
FIG. 12 is a schematic diagram of a connection structure of a transformer and an insulating board provided by yet another embodiment of the present application.
FIG. 13 is a schematic diagram of a connection structure of a transformer and an insulating board provided by yet another embodiment of the present application.
FIG. 14 is a schematic diagram of a connection structure of a transformer and an insulating board provided by yet another embodiment of the present application.
FIG. 15 is a structural diagram of a power module provided by another embodiment of the present application.
FIG. 16 is a structural diagram of a power module provided by still another embodiment of the present application.
FIG. 17 is a structural diagram of a transformer provided by yet another embodiment of the present application.
FIG. 18 is a schematic diagram of a connection structure of a transformer and an insulating board provided by yet another embodiment of the present application.
FIG. 19 is a structural diagram of a magnetic core provided by yet another embodiment of the present application.

### Reference signs:

11-First accommodating space; 12-Second accommodating space; 13-First power device; 14-Second power device; 15-Cover plate; 16-Fan;
100-Insulating board; 101-First side plate; 102-Second side plate; 110-Flat plate section; 120-Protrusion portion; 130-Connecting bridge; 140-Insulation cavity; 141-First insulation cavity; 142-Second insulation cavity;
200-Transformer; 210-Magnetic core; 211-First vertical pillar; 212-Second vertical pillar; 213-First transverse pillar; 214-Second transverse pillar; 215-First unit; 216-Second unit; 217-First longitudinal pillar; 218-Second longitudinal pillar; 220-First winding; 221-First part; 222-Second part; 230-Second winding; 231-First part; 232-Second part;
X-First direction; Y-Second direction; Z-Third direction.

### DESCRIPTION OF EMBODIMENTS

As described in the BACKGROUND, in related art, the insulating board in the power module is penetrated between the primary side unit and the secondary side unit of the transformer, causing a width of an air gap of the magnetic core of the transformer to be greater than a thickness of the insulating board, resulting in a larger size of the air gap of the magnetic core and reducing the efficiency of the transformer.

In view of this, embodiments of the present application aim to provide a power module, by setting a protrusion portion and a connecting bridge on an insulating board, a protrusion is formed by at least one of the protrusion portion and the connecting bridge to enclose at least one insulation cavity with the insulating board, at least part of the magnetic core of the transformer is set within the insulation cavity or the connecting bridge, so that the flat plate portion of the insulating board does not penetrate through an air gap of the magnetic core, which facilitates a control of a size of the air gap of the magnetic core and is beneficial for improving an efficiency of the transformer in the power module.

To make the purposes, technical solutions and advantages of embodiments of the present application more clearly, the technical solutions in the embodiments of the present application are clearly and completely described in the following with reference to the accompanying drawings of the embodiments of the present application. Obviously, the described embodiments are part of embodiments of the present application, not all embodiments.

Based on the embodiments of the present application, all other embodiments obtained by those skilled in the art without paying creative efforts are all within the protection scope of the present application. In the absence of conflict, the following embodiments and the features in the embodiments may be combined with each other.

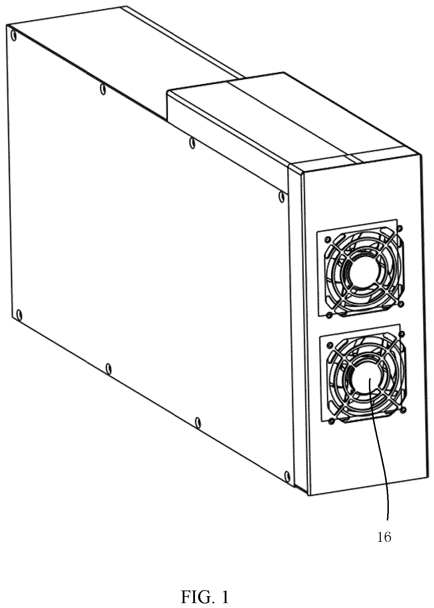

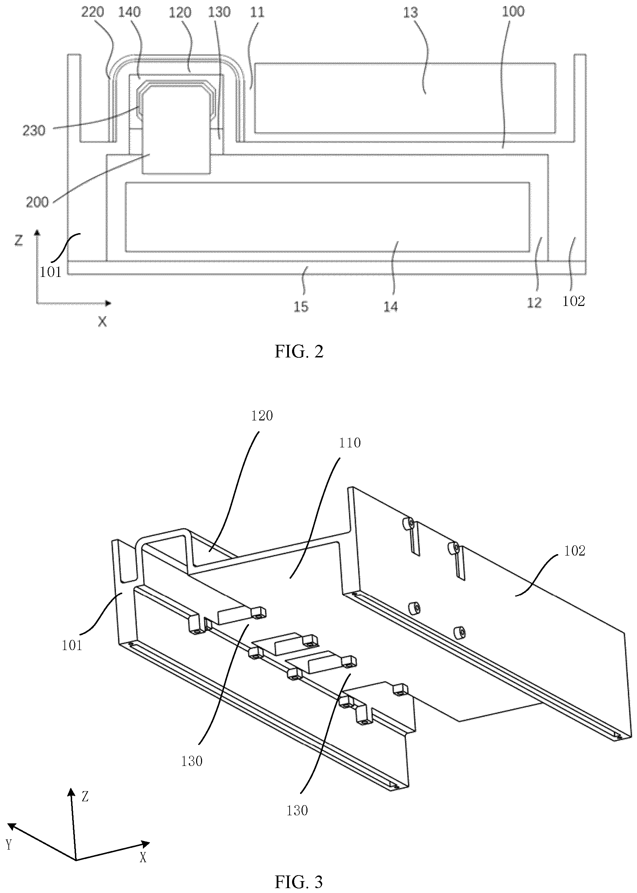

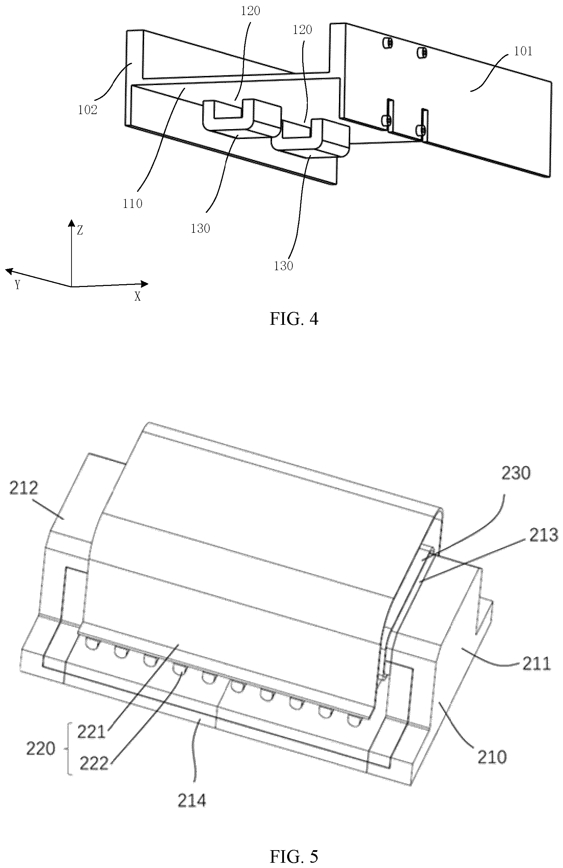

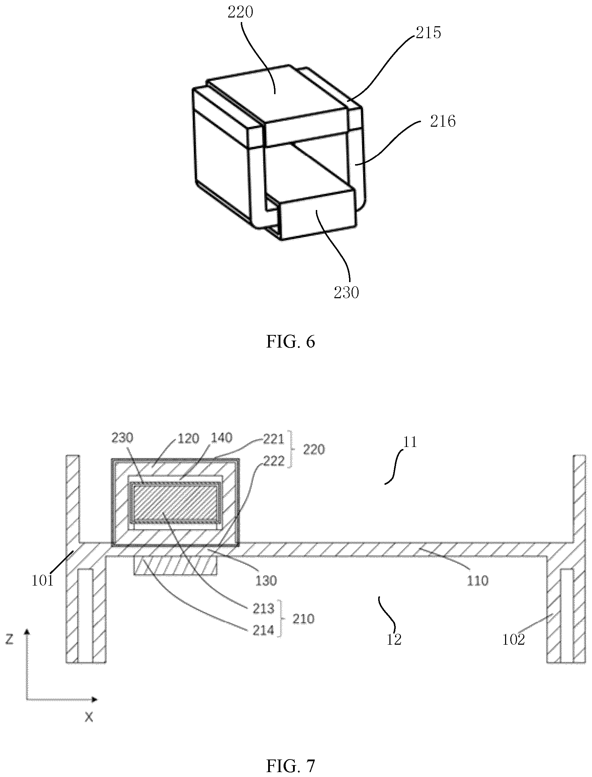

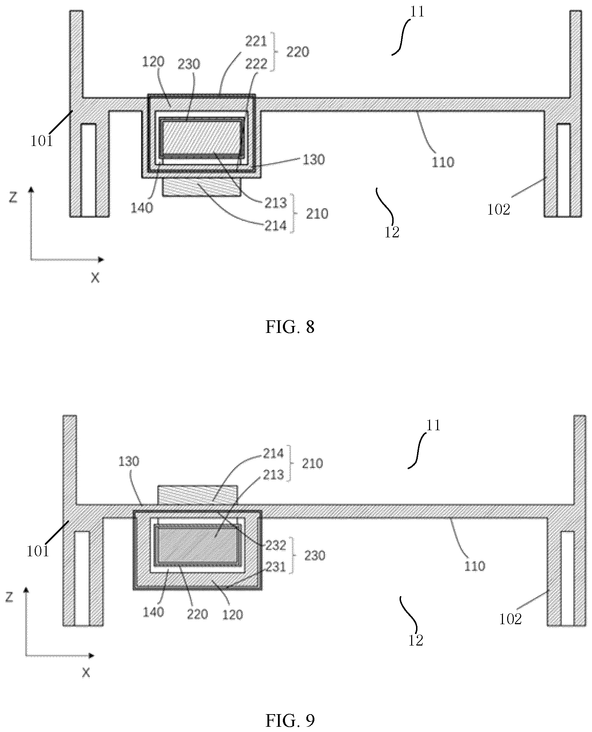

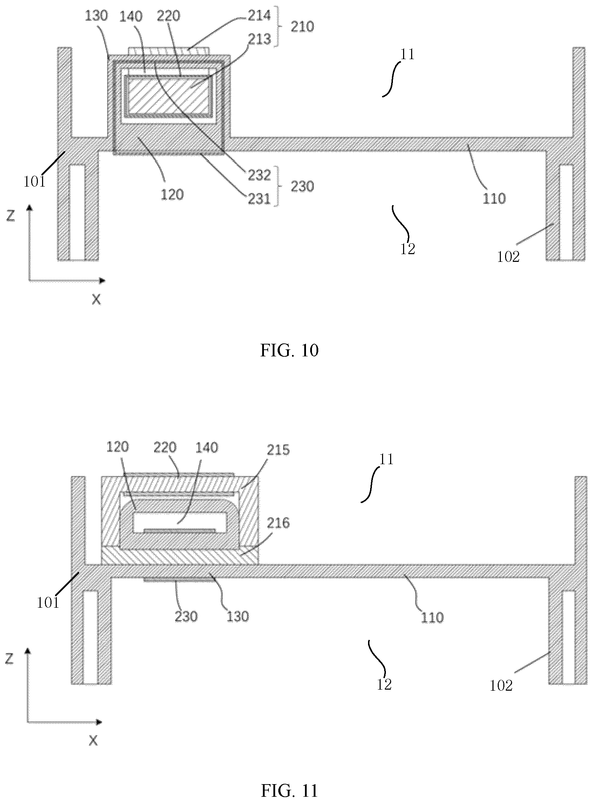

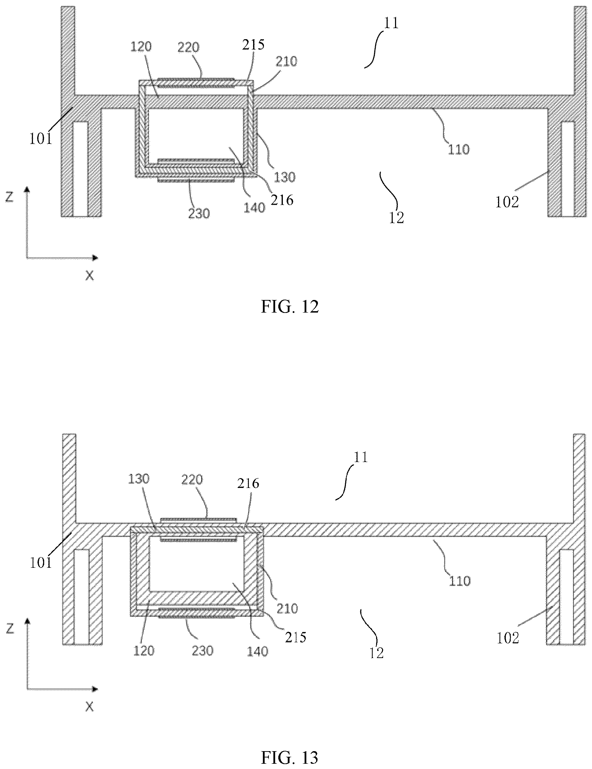

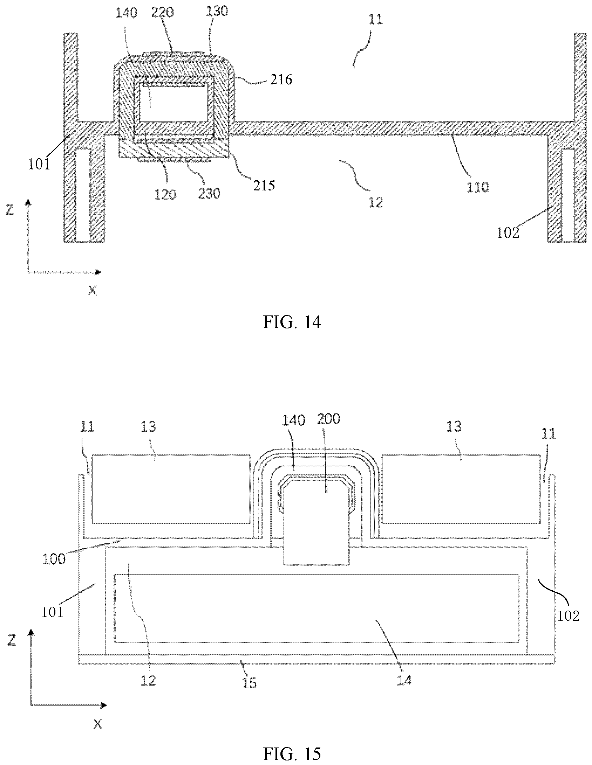

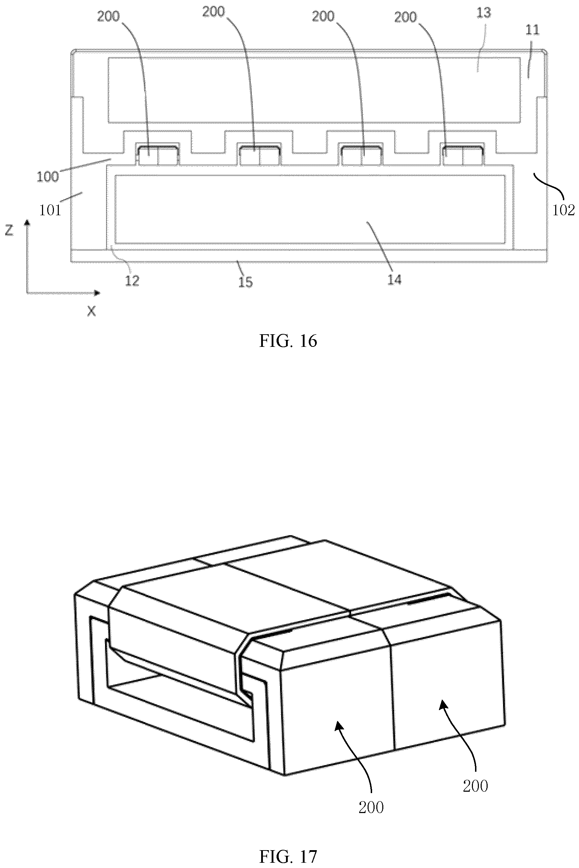

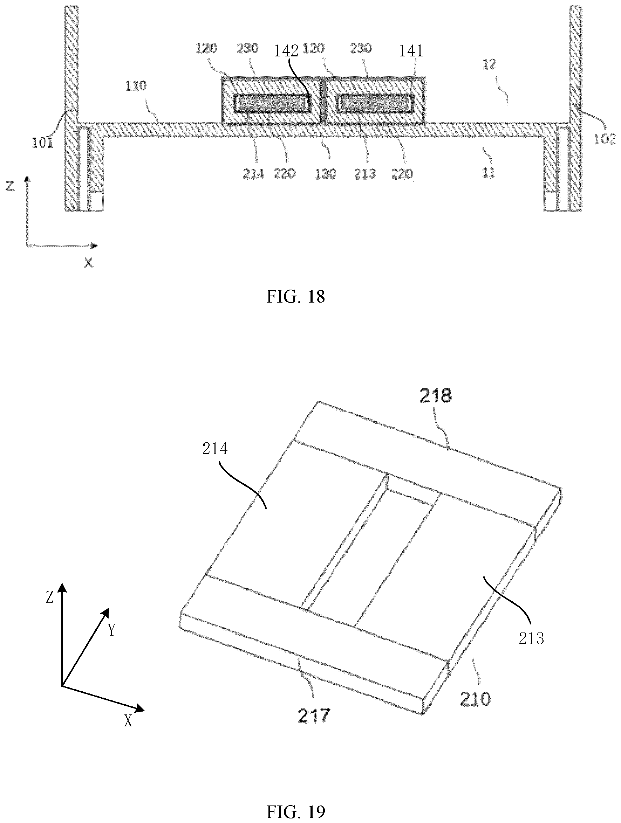

FIG. 1 is an external schematic diagram of a power module provided by an embodiment of the present application; FIG. 2 is a structural diagram of a power module provided by an embodiment of the present application; FIG. 3 is a structural diagram of an insulating board provided by an embodiment of the present application; FIG. 4 is a structural diagram of an insulating board provided by another embodiment of the present application; FIG. 5 is a structural diagram of a transformer provided by an embodiment of the present application; FIG. 6 is a structural diagram of a transformer provided by another embodiment of the present application; FIG. 7 is a schematic diagram of a connection structure of a transformer and an insulating board provided by an embodiment of the present application; FIG. 8 is a schematic diagram of a connection structure of a transformer and an insulating board provided by another embodiment of the present application; FIG. 9 is a schematic diagram of a connection structure of a transformer and an insulating board provided by still another embodiment of the present application; FIG. 10 is a schematic diagram of a connection structure of a transformer and an insulating board provided by yet another embodiment of the present application; FIG. 11 is a schematic diagram of a connection structure of a transformer and an insulating board provided by yet another embodiment of the present application; FIG. 12 is a schematic diagram of a connection structure of a transformer and an insulating board provided by yet another embodiment of the present application; FIG. 13 is a schematic diagram of a connection structure of a transformer and an insulating board provided by yet another embodiment of the present application; FIG. 14 is a schematic diagram of a connection structure of a transformer and an insulating board provided by yet another embodiment of the present application; FIG. 15 is a structural diagram of a power module provided by another embodiment of the present application; FIG. 16 is a structural diagram of a power module provided by still another embodiment of the present application; FIG. 17 is a structural diagram of a transformer provided by still another embodiment of the present application; FIG. 18 is a schematic diagram of a connection structure of a transformer and an insulating board provided by another embodiment of the present application; FIG. 19 is a structural diagram of a magnetic core provided by yet another embodiment of the present application.

It should be noted that in the embodiment, a first direction X, a second direction Y, and a third direction Z are three different directions perpendicular to each other in a three-dimensional space.

Please refer to FIG. 1, FIG. 2, FIG. 15, and FIG. 16, an embodiment provides a power module, which is provided with a first side plate 101, a second side plate 102, and an insulating board 100. In a third direction Z, the insulating board 100, the first side plate 101, and the second side plate 102 in combination form a first accommodating space 11 and a second accommodating space 12; the first accommodating space 11 is provided with a first power device 13 and at least part of a first winding 220, and the second accommodating space 12 is provided with a second power device 14, an insulation cavity 140 is connected to the second accommodating space 12 and has an equal potential, a second winding 230 is set within the insulation cavity 140. The first power device 13 may be, for example, a low-voltage power device, the second power device 14 may be, for example, a high-voltage power device, the first winding 220 may be a low-voltage winding, and the second winding 230 may be a high-voltage winding. The first side plate 101 and the second side plate 102 may be a single-layer structure or a double-layer structure. For example, when the first power device 13 is a low-voltage power device and the second power device 14 is a high-voltage power device, sides of the first side plate 101 and the second side plate 102 located on one side of the first accommodating space may each have a single-layer structure, and sides of the first side plate 101 and the second side plate 102 located on one side of the second accommodating space may each have a double-layer structure. In terms of production manner, the first side plate 101, the second side plate 102, and the insulating board 100 may be integrally-formed, or may be separately produced and assembled. A volume will be smaller for the integrally-formed case, so a volume of the power module may be reduced and a power density may be increased.

Optionally (in particular), as shown in FIG. 2 and FIG. 15, the power module also includes a cover plate 15. In the third direction Z, the cover plate 15 covers the second accommodating space 12 to form a relatively sealed structure, thereby improving a safety during use. Optionally, the power module may also include another cover plate to cover the first accommodating space 11 in the third direction Z. In other possible implementations, the first power device 13 may be a high-voltage power device, the second power device 14 may be a low-voltage power device, the first winding 220 may be a high-voltage winding, and the second winding 230 may be a low-voltage winding. In the third direction Z, the cover plate covers the first accommodating space 11 so as to make the first accommodating space form a relatively sealed structure, thereby improving the safety during use.

Please refer to FIG. 2, FIG. 3, and FIG. 4. In the embodiment, the insulating board 100 includes a flat plate portion 110, a protrusion portion 120, and a connecting bridge 130. Depending on actual application requirements, the insulating board 100 may include multiple protrusion portions 120 and multiple connecting bridges 130. The flat plate portion 110 is parallel to a plane formed by the first direction X and the second direction Y, and at least one of the protrusion portion 120 and the connecting bridge 130 protrude(s) along the third direction Z to jointly form an insulation cavity 140. The number of insulation cavities 140 may also be increased according to actual requirements. At least one of the protrusion portion 120 and the connecting bridge 130 in the embodiment may protrude along the third direction Z in a positive or negative direction (where the positive direction may be a direction indicated by an arrow in the figure, and the negative direction is opposite to the positive direction) relative to the flat plate portion 110. That is, as shown in FIG. 2 or FIG. 3, only the protrusion portion 120 protrudes while the connecting bridge 130 does not protrude to form an insulation cavity 140; or as shown in FIG. 4, only the connecting bridge 130 protrudes while the protrusion portion 120 does not protrude to form an insulation cavity 140; or both the protrusion portion 120 and the connecting bridge 130 protrude to form an insulation cavity 140; in practical application processes, a manner of forming the insulation cavity 140 may be selected as required. It should be noted that the protrusion portion 120 may also be integrated into the flat plate portion 110 as a whole, and protrusion is not a necessary requirement for the protrusion portion 120.

In the embodiment, along the second direction Y, both ends of the insulation cavity 140 are provided with openings to form a heat dissipation air duct, so air would be pulled through the heat dissipation air duct to cool the transformer 200.

For convenience of explanation, referring to FIG. 2, take the direction from the second accommodating space 12 to the first accommodating space 11 as the positive direction of the third direction Z, along the positive direction of the third direction Z, a position relationship between the protrusion portion 120 and the connecting bridge 130 may be the following two types: one is that the protrusion portion 120 is above the connecting bridge 130, and another is that the connecting bridge 130 is above the protrusion portion 120.

For example, in a possible implementation, as shown in FIG. 3, along the third direction Z, a distance between the connecting bridge 130 and the flat plate portion 110 is zero, that is, a bottom surface of the connecting bridge is flush with a bottom surface of the flat plate portion, and the protrusion portion 120 is set to protrude, at one side thereof, towards the first accommodating space 11. That is, in this implementation, the protrusion portion 120 may protrude towards the first accommodating space 11, while the connecting bridge 130 does not protrude, and the connecting bridge 130 and the flat plate portion 110 are both parallel to a plane formed by the first direction X and the second direction Y.

In other possible implementations, along the third direction Z, the distance between the connecting bridge 130 and the flat plate portion 110 is zero, and the protrusion portion 120 may also be set to protrude, at one side thereof, towards the second accommodating space 12. That is, in this implementation, the protrusion portion 120 may protrude towards the second accommodating space 12, while the connecting bridge 130 does not protrude, and the connecting bridge 130 and the flat plate portion 110 are both parallel to a plane formed by the first direction X and the second direction Y.

For example, in another possible implementation, as shown in FIG. 4, along the third direction Z, the distance between the protrusion portion 120 and the flat plate portion 110 is zero, and the connecting bridge 130 is set to protrude, at one side thereof, towards the second accommodating space 12. That is, in this implementation, the connecting bridge 130 may protrude towards the second accommodating space 12, while the protrusion portion 120 does not protrude, and the protrusion portion 120 and the flat plate portion 110 are both parallel to a plane formed by the first direction X and the second direction Y. At this time, the protrusion portion 120 and the flat plate portion 110 may be integrally-formed.

In other possible implementations, along the third direction Z, the distance between the protrusion portion 120 and the flat plate portion 110 is zero, and the connecting bridge 130 is set to protrude, at one side thereof, towards the first accommodating space 11. That is, in this implementation, the connecting bridge 130 may protrude towards the first accommodating space 11, while the protrusion portion 120 does not protrude, and the protrusion portion 120 and the flat plate portion 110 are both parallel to a plane formed by the first direction X and the second direction Y. At this time, the protrusion portion 120 and the flat plate portion 110 may be integrally-formed.

Please refer to FIG. 2, FIG. 5, and FIG. 6. In this embodiment, the power module further includes a transformer 200, which includes a magnetic core 210 and a winding wound on the magnetic core 210. The winding may be directly wound on the magnetic core 210 or indirectly wound on the magnetic core 210. The winding includes a first winding 220 and a second winding 230. The first winding 220 is electrically connected to a first power device 13, and the second winding 230 is electrically connected to a second power device 14. The transformer 200 may achieve a voltage conversion on both sides of the first power device 13 and the second power device 14.

In traditional power module structures, a size of an air gap of the magnetic core may generally only be adjusted in a thickness direction of an insulating board, that is, may be adjusted in the third direction Z, but due to limitations of the insulating board and an internal space, the air gap of the magnetic core cannot be flexibly adjusted, so that an overall design is limited. In this embodiment, at least part of the magnetic core 210 is set within the insulation cavity 140 or the connecting bridge 130, so that the air gap of the magnetic core may be adjusted on three directions: the first direction X, the second direction Y, and the third direction Z. The size of the air gap of the magnetic core may be freely adjusted according to electrical parameter requirements of the transformer 200, which greatly increases a flexibility in designing the magnetic core, and facilitates a control of a size and a tolerance of the air gap of the magnetic core, and an inductance value of the magnetic core, and beneficial for improving the efficiency of the transformer 200 in the power module. In addition, the setting of protrusion with respect to the protrusion portion 120 or the connecting bridge 130 on the flat plate portion 110 enables the insulating board 100 to form a bending structure, which is beneficial for improving an overall strength of the insulating board 100, so that a thinner insulating board 100 may meet the requirements, which is beneficial for reducing an overall weight of the power module.

In a possible implementation, the magnetic core 210 of this embodiment may be penetrated into the insulation cavity 140; that is, at least part of the magnetic core 210 is located within the insulation cavity 140. Part of the winding is set within the connecting bridge 130. The magnetic core 210 is provided with an opening along the first direction X, and the connecting bridge 130 is penetrated into the opening of the magnetic core 210. Referring to FIG. 5, FIG. 7, FIG. 8, FIG. 9, and FIG. 10, the magnetic core 210 includes a first vertical pillar 211 and a second vertical pillar 212 extending along the third direction Z, as well as a first transverse pillar 213 and a second transverse pillar 214 extending along the second direction Y. The first vertical pillar 211, the second vertical pillar 212, the first transverse pillar 213, and the second transverse pillar 214 in combination form an opening towards the first direction X, and the connecting bridge 130 is located between the first transverse pillar 213 and the second transverse pillar 214, the first transverse pillar 213 is located within the insulation cavity 140 formed by a combination of the connecting bridge 130 and the protrusion portion 120.

One of the first winding 220 or the second winding 230 in this embodiment may be directly wound on the magnetic core 210, and the other winding includes a first part and a second part interconnected. The first part is located on one side of the protrusion portion 120 away from the insulation cavity 140, and the second part is located within the connecting bridge 130. Optionally, the protrusion portion 120 may be of a hollow structure, and the first part of the other winding penetrates through a hollow portion of the protrusion portion 120; the protrusion portion 120 may also be of a solid structure, and the first part of the other winding is set within the protrusion portion 120 and is integrally-formed with the protrusion portion 120; or, an open groove is set on a surface of the side of the protrusion portion 120 away from the insulation cavity 140, and the first part of the other winding is set within the groove, the first part of the other winding is integrally-formed or independently set with the protrusion portion 120; or, the side of the protrusion portion 120 away from the insulation cavity 140 is set smoothly, without setting a groove, and the first part of the other winding is set on the surface of the side of the protrusion portion 120 away from the insulation cavity 140.

As shown in FIG. 7, in one embodiment, the protrusion portion 120 protrudes, at one side thereof, towards the first accommodating space 11, the connecting bridge 130 and the flat plate portion 110 are located within a same horizontal plane, the first transverse pillar 213 of the magnetic core 210 penetrates into the insulation cavity 140 enclosed by the protrusion portion 120 and the connecting bridge 130, and the connecting bridge 130 penetrates between the first transverse pillar 213 and the second transverse pillar 214 of the magnetic core 210. The second winding 230 is directly wound on the first transverse pillar 213; the first winding 220 includes two electrically connected parts, the first part 221 of the first winding 220 is set on the outside of the protrusion portion 120, and the second part 222 of the first winding 220 is set within the connecting bridge 130. In this embodiment, reference may be made to the structure shown in FIG. 5 for a winding manner of the windings. The first winding 220 includes the first part 221 and the second part 222, the first part 221 is located on the side of the protrusion portion 120 away from the insulation cavity 140, and the second part 222 is located within the connecting bridge 130. The second winding 230 is directly wound on the magnetic core 210, and the insulation cavity 140 is connected to the second accommodating space 12 and they have an equal potential.

Optionally, the first part 221 and the second part 222 of the first winding 220 may be integrally-formed, at this time, a through-hole is set within the connecting bridge 130 (i.e., the through-hole penetrates through an inside of the connecting bridge 130), the second part 222 is located within the through-hole.

Alternatively, the second part 222 may be integrally-formed with the connecting bridge 130. For example, the second part 222 may be directly embedded within the connecting bridge 130 during production. An end of the second part 222 is located outside the connecting bridge 130, and an end of the first part 221 is electrically connected to the end of the second part 222. Specifically, the end of the first part 221 may be electrically connected to the end of the second part 222 through welding or in other manners.

As shown in FIG. 8, in one embodiment, the protrusion portion 120 and the flat plate portion 110 are located within the same horizontal plane, and the connecting bridge 130 protrudes, at one side thereof, towards the second accommodating space 12, the first transverse pillar 213 of the magnetic core 210 penetrates into the insulation cavity 140 enclosed by the protrusion portion 120 and the connecting bridge 130. In this embodiment, the connecting bridge 130 is U-shaped, and part of the connecting bridge 130 penetrates between the first transverse pillar 213 and the second transverse pillar 214 of the magnetic core 210. In this embodiment, the second winding 230 is directly wound on the magnetic core 210, preferably directly wound on the first transverse pillar 213; the first winding 220 includes two electrically connected parts, the first part 221 of the first winding 220 is set on the outside of the protrusion portion 120, the second part 222 of the first winding 220 is set within the connecting bridge 130, and the insulation cavity 140 is connected to the second accommodating space 12.

As shown in FIG. 9, in one embodiment, the protrusion portion 120 protrudes, at one side thereof, towards the second accommodating space 12, the connecting bridge 130 and the flat plate portion 110 are located within the same horizontal plane, the first transverse pillar 213 of the magnetic core 210 penetrates into the insulation cavity 140 enclosed by the protrusion portion 120 and the connecting bridge 130, and the connecting bridge 130 penetrates between the first transverse pillar 213 and the second transverse pillar 214 of the magnetic core 210. In this embodiment, the first winding 220 is directly wound on the magnetic core 210, preferably directly wound on the first transverse pillar 213; the second winding 230 includes two electrically connected parts, the first part 231 of the second winding 230 is set on the outside of the protrusion portion 120, and the second part 232 of the second winding 230 is set within the connecting bridge 130, the insulation cavity 140 is connected to the first accommodating space 11.

As shown in FIG. 10, in one embodiment, the protrusion portion 120 and the flat plate portion 110 are located within the same horizontal plane, and the connecting bridge 130 protrudes, at one side thereof, towards the first accommodating space 11, the first transverse pillar 213 of the magnetic core 210 penetrates into the insulation cavity 140 enclosed by the protrusion portion 120 and the connecting bridge 130. In this embodiment, the connecting bridge 130 is U-shaped, and part of the connecting bridge 130 penetrates between the first transverse pillar 213 and the second transverse pillar 214 of the magnetic core 210. In this embodiment, the first winding 220 is directly wound on the magnetic core 210, preferably directly wound on the first transverse pillar 213; the second winding 230 includes two electrically connected parts, the first part 231 of the second winding 230 is set on the outside of the protrusion portion 120, the second part 232 of the second winding 230 is set within the connecting bridge 130, and the insulation cavity 140 is connected to the first accommodating space 11.

In the embodiments shown in FIG. 7, FIG. 8, FIG. 9, and FIG. 10, the insulation cavity 140 is provided with an opening in the second direction Y. Referring to FIG. 1 and FIG. 3, an airflow generated by a fan 16 may pass along the second direction Y, heat generated by the transformer arranged in the insulation cavity 140 may be directly carried away by the airflow, a heat dissipation efficiency is greatly improved, which is beneficial for reducing a volume of the power module and increasing a power density.

In another possible implementation, the connecting bridge 130 is provided with a through-hole in the first direction X, and the magnetic core 210 may be penetrated into the connecting bridge 130; that is, at least part of the magnetic core 210 is located within the connecting bridge 130. Referring to FIG. 6, FIG. 11, FIG. 12, FIG. 13, and FIG. 14, the magnetic core 210 includes a first unit 215 and a second unit 216. The first unit 215 is located on one side of the protrusion portion 120 away from the insulation cavity 140, and the second unit 216 is fully or partially penetrated into the connecting bridge 130, the second unit 216 may be integrally-formed with the connecting bridge 130. Optionally, the protrusion portion 120 may be of a hollow structure, and the second unit 216 penetrates through a hollow portion of the protrusion portion 120; the protrusion portion 120 may also be of a solid structure, the second unit 216 is set within the protrusion portion 120 and is integrally-formed with the protrusion portion 120; an open groove is provided on a surface of the protrusion portion 120 away from the insulation cavity 140, and the second unit 216 is set within the groove, the second unit 216 is independently set or integrally-formed with the protrusion portion 120; or, the side of the protrusion portion 120 away from the insulation cavity 140 is set smoothly, without setting a groove, and the second unit 216 is set on the surface of the protrusion portion 120 away from the insulation cavity 140. Optionally, the magnetic core 210 may only include the second unit 216 that penetrates into the connecting bridge, which is an 1-type magnetic core, and there is no magnetic core 210 outside the protrusion portion 120. In this implementation, based on the different structures of the protrusion portion 120 and the connecting bridge 130, the following embodiments can be included.

As shown in FIG. 11, in one embodiment, the protrusion portion 120 protrudes, at one side thereof, towards the first accommodating space 11, and the connecting bridge 130 and the flat plate portion 110 are located within the same horizontal plane. The magnetic core 210 includes the first unit 215 and the second unit 216, and the first unit 215 and the second unit 216 may be in direct contact or have a certain gap there between in the third direction Z. The first unit 215 is U-shaped and covers the outside of the protrusion portion 120, while the second unit 216 is roughly strip-shaped in the first direction X and is set within the connecting bridge 130. Another feasible manner not shown in FIG. 11 is that the first unit 215 of the magnetic core 210 is located on the outside of the protrusion portion 120, and the second unit 216 is U-shaped and partially penetrated into the connecting bridge 130. The second unit 216 may be integrally-formed with the connecting bridge 130. The first winding 220 is wound on the first unit 215 of the magnetic core 210, the first winding 220 may be wound on at least one of a transverse pillar and vertical pillars of the first unit 215, or the first winding 220 may be wound on the second unit 216 of the magnetic core 210 set within the connecting bridge 130. The second winding 230 is wound on the connecting bridge 130, and the insulation cavity 140 is connected to the second accommodating space 12.

As shown in FIG. 12, in one embodiment, the protrusion portion 120 and the flat plate portion 110 are located within the same horizontal plane, and the connecting bridge 130 protrudes, at one side thereof, towards the second accommodating space 12. The magnetic core 210 includes the first unit 215 and the second unit 216, the first unit 215 and the second unit 216 may be in direct contact or have a certain gap there between in the third direction Z. The first unit 215 of the magnetic core 210 is located on the outside of the protrusion portion 120, and the second unit 216 of the magnetic core 210 is U-shaped and penetrated into the connecting bridge 130. Another feasible manner not shown in FIG. 12 is that the first unit 215 is also U-shaped, and a part of the first unit 215 is located on the outside of the protrusion portion 120 and another part is penetrated into the connecting bridge 130 along the third direction Z. At this time, the second unit 216 may be U-shaped or may be strip-shaped in the first direction X. The second unit 216 may be integrally-formed with the connecting bridge 130. The first winding 220 located within the first accommodating space 11 is wound on the first unit 215 of the magnetic core 210 outside the protrusion portion 120, the second winding 230 is wound on the connecting bridge 130, and the second winding 230 is partially located in the second accommodating space 12 and partially located in the insulation cavity 140, the insulation cavity 140 is connected to the second accommodating space 12, which can be understood as the second winding 230 being fully located within the second accommodating space 12. Specifically, the second winding 230 may be wound around at least one of a horizontal portion and vertical portions of the connecting bridge 130.

As shown in FIG. 13, in one embodiment, the protrusion portion 120 protrudes, at one side thereof, towards the second accommodating space 12, and the connecting bridge 130 and the flat plate portion 110 are located within the same horizontal plane. The magnetic core 210 includes the first unit 215 and the second unit 216, the first unit 215 and the second unit 216 may be in direct contact or have a certain gap there between in the third direction Z. The first unit 215 is U-shaped and covers the outside of the protrusion portion 120, while the second unit 216 is roughly strip-shaped in the first direction X and is fully located within the connecting bridge 130. Another feasible manner not shown in FIG. 13 is that the first unit 215 of the magnetic core 210 is located on the outside of the protrusion portion 120, and the second unit 216 is U-shaped and partially penetrated into the connecting bridge 130. The second unit 216 may be integrally-formed with the connecting bridge 130. The first winding 220 is wound on the connecting bridge 130, and the first winding 220 is partially located within the first accommodating space 11, and partially in the insulation cavity 140, the insulation cavity 140 is connected to the first accommodating space 11, which may be understood as the first winding 220 being fully located within the first accommodating space 11, and the second winding 230 located within the second accommodating space 12 being wound on the magnetic core 210 outside the protrusion portion 120.

As shown in FIG. 14, in one embodiment, the protrusion portion 120 and the flat plate portion 110 are located within the same horizontal plane, and the connecting bridge 130 protrudes, at one side thereof, towards the first accommodating space 11. The magnetic core 210 includes the first unit 215 and the second unit 216, the first unit 215 and the second unit 216 may be in direct contact or have a certain gap there between in the third direction Z. The first unit 215 of the magnetic core 210 is located on the outside of the protrusion portion 120, and the second unit 216 of the magnetic core 210 is U-shaped and penetrated into the connecting bridge 130. Another feasible manner not shown in FIG. 14 is that the first unit 215 is U-shaped, a part of the first unit 215 is located on the outside of the protrusion portion 120, and another part is penetrated into the connecting bridge 130 along the third direction Z. At this time, the second unit 216 may be U-shaped or may be strip-shaped in the first direction X. The second unit 216 may be integrally-formed with the connecting bridge 130. The first winding 220 is wound on the connecting bridge 130, and the first winding 220 is partially located within the first accommodating space 11 and partially in the insulation cavity 140, the insulation cavity 140 is connected to the first accommodating space 11, which can be understood as the first winding 220 being fully located within the first accommodating space 11, and the second winding 230 located within the second accommodating space 12 being wound on the magnetic core 210 outside the protrusion portion 120.

In the embodiments shown in FIG. 11 to FIG. 14, by setting the winding outside the insulation cavity 140, the winding is not insulated, which is more conducive to a heat dissipation. Since a loss of the winding of the transformer is greater than a loss of the magnetic core, setting the winding outside the insulation cavity 140 may further improve the efficiency of the transformer 200. In addition, in the embodiment, the winding does not need to penetrate through an interior of the connecting bridge 130, and a connection of incoming and outgoing lines is simple; and at this time, a smooth air duct may be formed within the insulation cavity 140 in the second direction Y, which is more beneficial to the heat dissipation.

The surface of the insulating board 100 disclosed in the embodiment may be provided with a semi conductive layer, and materials of the semi conductive layer may include a graphene or a carbon black for shielding and other purposes. Common parameters for semi conductive coatings would include a thickness (10um∼200um), a conductivity range (10^(-11) s/m∼10^(3) s/m), but not limited thereto.

The insulation cavity 140 disclosed in the embodiment has openings at both ends along the second direction Y, that is, the interior of the insulation cavity 140 is conductive in the second direction Y, thus enabling the airflow generated by the fan 16 to directly act on the transformer 200, to directly take away the heat generated by the transformer 200, thereby greatly improving the efficiency of the heat dissipation, as well as reducing the volume of the power module, and increasing the power density.

In another embodiment, the power module may also have a structure as shown in FIG. 15, that is, along the first direction X, the insulation cavity 140 is located at a middle of the insulating board 100, and the corresponding transformer 200 is also located at the middle of the insulating board 100.

By adopting the above structure, the first accommodating space 11 may be distributed on both sides of the insulation cavity 140. Compared with the structure shown in FIG. 2, where the insulation cavity 140 is set near an edge of the insulating board 100, the structure shown in FIG. 15 is more advantageous for an arrangement of the first power device 13 in a limited space, which greatly improves space utilization, is beneficial for reducing the volume of the power module, and increment of the power density.

In another embodiment, the power module may also have a structure as shown in FIG. 16, the insulating board 100 may be provided with multiple insulation cavities 140. At this time, the power module includes multiple transformers 200, and multiple transformers 200 correspond to multiple insulation cavities 140, according to different circuit structures, at least one transformer 200 may also be placed in one insulation cavity. In this embodiment, multiple transformers 200 may be connected in series or parallel. As shown in FIG. 17, in this embodiment, two transformers 200 connected in series are provided in one insulation cavity 140, and transformers 200 in multiple insulation cavities 140 may be connected in parallel with each other.

By adopting the above structure, a size of a single transformer 200 may be reduced, and a height of the insulation cavity 140 may be reduced, so that the first power device 13 and the second power device 14 may be closer to the transformer 200, which is beneficial for saving space, reducing the volume of the power module, and increasing the power density.

In another embodiment, the magnetic core 210 is provided with a through-hole along the third direction Z, and at this time, the insulating board 100 includes multiple protrusion portions 120 and multiple connecting bridges 130, the multiple protrusion portions 120 and multiple connecting bridges 130 in combination form multiple insulation cavities 140. As shown in FIG. 18, the insulating board 100 includes at least two insulation cavities 140, taking two insulation cavities 140 as an example, they are a first insulation cavity 141 and a second insulation cavity 142 respectively, both of them are provided with magnetic cores 210. Referring to FIG. 19, the magnetic core 210 includes a first longitudinal pillar 217 and a second longitudinal pillar 218 extending along the first direction X, as well as a first transverse pillar 213 and a second transverse pillar 214 extending along the second direction Y. The combination of the first longitudinal pillar 217, the second longitudinal pillar 218, the first transverse pillar 213, and the second transverse pillar 214 forms an opening towards the third direction Z. The first winding 220 is set within the insulation cavity 140, the second winding 230 is partially set within the connecting bridge 130, and partially set within the second accommodating space 12.

The protrusion portion 120 protrudes, at one side thereof, towards the second accommodating space 12, and the connecting bridge 130 and the flat plate portion 110 are located within the same horizontal plane. The first transverse pillar 213 and the second transverse pillar 214 of the magnetic core 210 are respectively penetrated into the first insulation cavity 141 and the second insulation cavity 142. In this embodiment, the number of windings is not limited, for example, there are two first windings 220 and two second windings 230, the two first windings 220 are directly wound on the first transverse pillar 213 and the second transverse pillar 214 respectively; the two second windings 230 both include two electrically connected parts, the first parts 231 of the two second windings 230 are respectively set on the outsides of the protrusion portions 120 forming the first insulation cavity 141 and the second insulation cavity 142, the second parts 232 of the two second windings 230 are respectively set within the connecting bridges 130 forming the first insulation cavity 141 and the second insulation cavity 142. That is, the first transverse pillar 213 is wound by the first winding 220 and the second winding 230, the second transverse pillar 214 is also wound by the first winding 220 and the second winding 230. The first winding 220 wound on different transverse pillars may be electrically connected in series or parallel, and the second winding 230 wound on different transverse pillars may be electrically connected in series or parallel. By adopting this structure, a module output assembly is flexible.

Other feasible manners not shown in FIG. 18 include: the protrusion portion 120 and the flat plate portion 110 are located within the same horizontal plane, and the connecting bridge 130 protrudes, at one side thereof, towards the first accommodating space 11; or, the connecting bridge 130 protrudes, at one side thereof, towards the second accommodating space 12, the protrusion portion 120 and the flat plate portion 110 are located within the same horizontal plane; or, the connecting bridge 130 and the flat plate portion 110 are located within the same horizontal plane, and the protrusion portion 120 protrudes, at one side thereof, towards the first accommodating space 11.

## Claims

1. A power module, comprising:
a first side plate (101), a second side plate (102), and an insulating board (100);
the insulating board (100) comprising a flat plate portion (110), at least one protrusion portion (120), and at least one connecting bridge (130), the flat plate portion (110) being parallel to a plane formed by a first direction (X) and a second direction (Y); at least one of the protrusion portion (120) and the connecting bridge (130) protruding along a third direction (Z) to form an insulation cavity (140); the insulating board (100), the first side plate (101), and the second side plate (102) in combination forming a first accommodating space (11) and a second accommodating space (12) along the third direction (Z); the first accommodating space (11) being provided with a first power device (13), and the second accommodating space (12) being provided with a second power device (14); and
a transformer (200), comprising a magnetic core (210) and a winding wound on the magnetic core (210), the winding comprising a first winding (220) and a second winding (230), at least part of the magnetic core (210) being set within the insulation cavity (140) or the connecting bridge (130); the first winding (220) being electrically connected to the first power device (13), and the second winding (230) being electrically connected to the second power device (14);
wherein the first direction (X), the second direction (Y), and the third direction (Z) are perpendicular to each other.

2. The power module according to claim 1, wherein the at least part of the magnetic core (210) is set within the insulation cavity (140), and a part of the winding is set within the connecting bridge (130).

3. The power module according to claim 2, wherein the magnetic core (210) is provided with an opening along the first direction (X), and part of the connecting bridge (130) is penetrated into the opening of the magnetic core (210);
optionally, the magnetic core (210) comprises a first vertical pillar (211) and a second vertical pillar (212) extending along the third direction (Z), as well as a first transverse pillar (213) and a second transverse pillar (214) extending along the second direction (Y), the first vertical pillar (211), the first transverse pillar (213), the second vertical pillar (212), and second transverse pillar (214) are connected head-to-tail in sequence, and the first transverse pillar (213) is located within the insulation cavity (140).

4. The power module according to claim 2 or 3, wherein one of the first winding (220) and the second winding (230) is directly wound on the magnetic core (210), and the other of the first winding (220) and the second winding (230) comprises a first part (221, 231) and a second part (222, 232) connected electrically, the first part (221, 231) is located on one side of the protrusion portion (120) away from the insulation cavity (140), and the second part (222, 232) is located within the connecting bridge (130);
optionally,
the first part (221, 231) is integrally-formed with the second part (222, 232), and a through-hole is set within the connecting bridge (130), and the second part (222, 232) is located within the through-hole; or
the second part (222, 232) is integrally-formed with the connecting bridge (130), an end of the second part (222, 232) is located outside the connecting bridge (130), and an end of the first part (221, 231) is electrically connected to the end of the second part (222, 232).

5. The power module according to one of claim 1, wherein the at least part of the magnetic core (210) is set within the connecting bridge (130).

6. The power module according to claim 5, wherein the magnetic core (210) comprises a first unit (215) and a second unit (216), the first unit (215) is located on one side of the protrusion portion (120) away from the insulation cavity (140), and the second unit (216) is penetrated into the connecting bridge (130);
optionally,
the first winding (220) is wound on the first unit (215), the second winding (230) is wound on the connecting bridge (130), the first winding (220) is set within the first accommodating space (11), and the second winding (230) is set within the second accommodating space (12); or
the second winding (230) is wound on the first unit (215), the first winding (220) is wound on the connecting bridge (130), the first winding (220) is set within the first accommodating space (11), and the second winding (230) is set within the second accommodating space (12).

7. The power module according to claim 5 or 6, wherein the connecting bridge (130) is provided with a through-hole along the first direction (X), and the at least part of the magnetic core (210) is penetrated into the through-hole; or
wherein the at least part of the magnetic core (210) is integrally-formed with the connecting bridge (130); or
wherein one of the first winding (220) and the second winding (230) is directly wound on the magnetic core (210) located within the connecting bridge (130), and the other of the first winding (220) and the second winding (230) is wound on the connecting bridge (130).

8. The power module according to claim 1, wherein the insulating board (100) comprises multiple protrusion portions (120) and multiple connecting bridges (130), and along the first direction (X), the multiple protrusion portions (120) and the multiple connecting bridges (130) form multiple insulation cavities (140); the power module comprises multiple transformers (200), the multiple transformers (200) correspond to the multiple insulation cavities (140), and the multiple transformers (200) are connected in series or parallel.

9. The power module according to any one of claims 1 to 8, wherein along the third direction (Z), a distance of the connecting bridge (130) and the flat plate portion (110) is zero, and the protrusion portion (120) is set to be protuberant, at one side thereof, towards the first accommodating space (11) or the second accommodating space (12); or
wherein along the third direction (Z), a distance of the protrusion portion (120) and the flat plate portion (110) is zero, and the connecting bridge (130) is set to be protuberant, at one side thereof, towards the first accommodating space (11) or the second accommodating space (12).

10. The power module according to any one of claims 1 to 8, wherein a surface of the insulating board (100) is provided with a semi conductive layer;
optionally, a material of the semi conductive layer comprises a graphene or a carbon black.

11. The power module according to claim 1, wherein along the second direction (Y), both ends of the insulation cavity (140) are provided with openings.

12. The power module according to claim 1, further comprising a cover plate (15), the cover plate (15) covers the second accommodating space (12) along the third direction (Z), and the second power device (14) comprises a high-voltage power device;
optionally, sides of the first side plate (101) and the second side plate (102) located within the second accommodating space (12) are of double-layer structures.

13. The power module according to claim 2, wherein the magnetic core (210) is provided with an opening along the third direction (Z), and part of the connecting bridge (130) or the protrusion portion (120) is penetrated into the opening of the magnetic core (210).

14. The power module according to claim 13, wherein the insulating board (100) comprises multiple protrusion portions (120) and multiple connecting bridges (130), and the multiple protrusion portions (120) and the multiple connecting bridges (130) form at least two insulation cavities (140);
the magnetic core (210) comprises a first longitudinal pillar (217) and a second longitudinal pillar (218) extending along the first direction (X), as well as a first transverse pillar (213) and a second transverse pillar (214) extending along the second direction (Y), the first longitudinal pillar (217), the first transverse pillar (213), the second longitudinal pillar (218), and the second transverse pillar (214) are connected head-to-tail in sequence, and the first transverse pillar (213) and the second transverse pillar (214) are penetrated into different insulation cavities (140) respectively.

15. The power module according to claim 14, wherein the winding comprises two first windings (220) and two second windings (230), the two first windings (220) are wound on the first transverse pillar (213) and the second transverse pillar (214) respectively, each of the two second windings (230) comprises a first part (231) and a second part (232) connected electrically; first parts (231) of the two second windings (230) are respectively set on one side of the protrusion portion (120) of the insulation cavity (140) away from the insulation cavity (140), with the insulation cavity (140) being penetrated by the first transverse pillar (213) and the second transverse pillar (214); second parts (232) of the two second windings (230) are respectively set within the connecting bridge (130) of the insulation cavity (140), with the insulation cavity (140) being penetrated by the first transverse pillar (213) and the second transverse pillar (214); the two first windings (220) are both set within the first accommodating space (11); or
wherein the winding comprises two first windings (220) and two second windings (230), the two second windings (230) are wound on the first transverse pillar (213) and the second transverse pillar (214) respectively, each of the two first windings (220) comprises a first part (221) and a second part (222) connected electrically; first parts (221) of the two first windings (220) are respectively set on one side of the protrusion portion (120) of the insulation cavity (140) away from the insulation cavity (140), with the insulation cavity (140) being penetrated by the first transverse pillar (213) and the second transverse pillar (214), and second parts (222) of the two first windings (220) are respectively set within the connecting bridge (130) of the insulation cavity (140), with the insulation cavity (140) being penetrated by the first transverse pillar (213) and the second transverse pillar (214); the two second windings (230) are both set within the first accommodating space (11).
